# EUROPEAN PATENT SPECIFICATION

(11) **EP 0 868 805 B1**
(45) Date of publication and mention of the grant of the patent: **20.03.2002**
(21) Application number: 96944437.1
(22) Date of filing: 18.12.1996
(51) Int. Cl.: H04M 1/00, H04M 1/82

(54) **MODEM LOOP CURRENT DETECT SYSTEM TO DETECT AN OFF-HOOK CONDITION IN AN EXTENSION TELEPHONE**
MODEMSCHLEIFENSTROMERKENNUNGSSYSTEM ZUR DETEKTION EINES SCHLEIFENSCHLUSSZUSTANDS IN EINER NEBENSPRECHSTELLE
SYSTEME DE DETECTION DE COURANT DE BOUCLE DANS UN MODEM PERMETTANT DE DECELER UN DECROCHAGE SUR UN POSTE TELEPHONIQUE SUPPLEMENTAIRE

(30) Priority: 22.12.1995 US 9178; 02.01.1996 GB 9600002; 28.06.1996 GB 9613608
(43) Date of publication of application: 07.10.1998
(73) Proprietor: THOMSON CONSUMER ELECTRONICS, INC., Indianapolis, IN 46290-1024 (US)
(72) Inventor: PITSCH, Robert, Alan, Indianapolis, IN 46236 (US)
(74) Representative: Rossmanith, Manfred, Dr.
(86) International application number: PCT/US96/20117
(87) International publication number: WO 97/23985

(56) References cited:
- EP-A- 0 338 654
- WO-A-95/14344
- US-A- 4 203 006
- US-A- 4 807 278
- US-A- 5 291 545
- US-A- 5 422 939

## Description

The subject invention generally concerns the field of telephone line monitoring circuits.

Modern satellite television systems such as the RCA DSS® system, manufactured by Thomson Consumer Electronics, Inc., Indianapolis, Indiana, include circuitry for automatically calling a predetermined telephone number to report the billable specifics regarding the use of the customer's integrated receiver decoder (IRD). Such billing is necessary, of course, because the user receives programming by subscribing to one or more of several program providers. Unfortunately, there is no time of day at which the IRD is guaranteed access to the telephone line, because the user may be placing a call, literally anytime (one cannot schedule emergencies, for example). It is desirable, therefore to be able to detect a condition in which the user picks up an extension phone, in order that the IRD may release the line to the user. However, heretofore the operation of telephone line monitoring circuitry has been somewhat inadequate, due to the drift of the state of the voltage provided by the telephone company. Many factors affect the telephone voltage level delivered to the user's home, such as, the length of the line from the central office, fluctuations in the signals in the line cards used at the central office, whether the connections to the user's home have become corroded, etc. The problem at hand is how to accurately determine if an extension telephone is picked up (causing a perturbation in the line voltage level) given the real world situation wherein changes in line level may be the norm.

Moreover, the measurement is even more complicated by the fact that one cannot reliably measure telephone line voltage at the user's location with respect to the user's ground reference without risking the introduction of ground loop voltages. It also must be noted that because devices coupled to telephone networks are required to have a relatively high input impedance, they tend to be susceptible to picking up noise transients, which may interfere with the measurement of the telephone line level.

European Patent Application No. 0 338 654 discloses a method and apparatus for use in an automatic tele-communication system for controlling communication by a modem over a telephone line. Means are provided for determining prior to initiating communication by the modem over the telephone line whether a telephone connected to the telephone line is off hook and for inhibiting communication by the modem over the telephone line if a telephone is off hook. The same means or further means are arranged for determining during communication by the modem over the telephone line whether a telephone connected to the telephone line goes off hook and for terminating such communication if a telephone goes off hook so as to release the telephone line for use by the telephone.

International Patent Application No. WO 95/14344 discloses a telephone line monitoring circuit for a MODEM monitors the TIP and RING lines of the telephone line. A first connecting circuit detects when a local phone goes off-hook while the MODEM is on-hook by sensing a decrease in a differential voltage between the TIP and RING lines. A second circuit detects the pick up of a local phone while the MODEM is off-hook by detecting a change in the impedance between the TIP and RING lines. A third circuit detects the hang up of a remote phone connected with the MODEM while the MODEM is off-hook by detecting a temporary break in the DC loop between the central office and MODEM. A snoop circuit monitors the telephone line for DTMF signals while the MODEM is on-hook.

A telephone line monitoring circuit uses a converting device such as an optoisolator to convert the telephone line current to a voltage which is applied to the input of an A/D converter. The A/D values are coarse values representing telephone line current. The A/D is sampled at a predetermined interval to identify changes introduced by the telephone company central office, and to take those changes into account when deciding if an extension telephone has gone off-hook. When a customer causes an extension telephone to go off-hook, the line current divides between the extension telephone and the IRD modem, and such change is detected.
FIGURE 1 shows telephone line monitoring circuitry suitable for use with the invention;
FIGURE 2 shows a table of line current values and A/D readings useful in understanding the invention; and
FIGURE 3 shows an alternate embodiment of a telephone line monitoring circuit in accordance with the invention.

A telephone line monitoring circuit having the capability to detect extension phone pick-up will now be described with reference to the FIGURES.

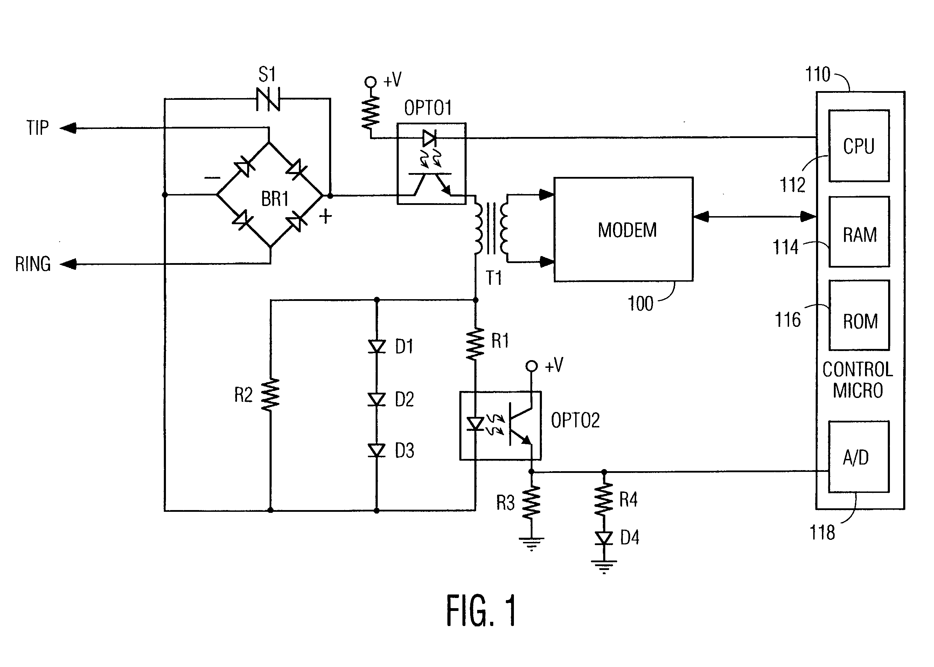

Referring to FIGURE 1, a diode bridge arrangement BR1 is coupled to a telephone network (not shown), via TIP and RING terminals, for providing communication to and from consumer electronics equipment, the relevant portions of which are illustrated in FIGURE 1. A Sidactor®, manufactured by TECCOR Inc., (a bidirectional diac) S1 is coupled across the plus and minus terminals of bridge BR1 to protect the circuitry further coupled to the bridge. Briefly, a Sidactor® is a protection device having an operational characteristic such that, after a breakover voltage is achieved, as the current through the device goes up, its impedance goes down. Its function in the arrangement of FIGURE 1 is to limit the voltage developed across OPTO 1. OPTO1 is a darlington optoisolator, and is used as an electronic equivalent of a "hookswitch" for connecting the equipment to the telephone network for placing a call. OPTO 1 operates under control of a system control microcomputer (µC) 110. The terms "microcomputer", controller, and "microprocessor", as used herein, are equivalent. It is also recognized that the control function of microcomputer 110 may be performed by an integrated circuit especially manufactured for that specific purpose (i.e., a "custom chip"), and the term "controller", as used herein, is also intended to include such a device. Microcomputer 110 includes a central processing unit (CPU) 112, a program memory (ROM) 116, and stores short term data in a random-access memory (RAM) 114. RAM 114 may be either internal to, or external to, microprocessor 110, and may be of either the volatile or non-volatile type. The term "RAM" is also intended to include electrically-erasable programmable read only memory (EEPROM). One skilled in the art will recognize that if volatile memory is utilized, that it may be desirable to use a suitable form of standby power (such as from a backup battery) to preserve its contents during power outages.

Optoisolator OPTO1 couples signals to and from a modem 100 via an isolation transformer T1. The telephone company loop current present in the primary winding of transformer T1 is also applied via a resistor R1 to a second optoisolator OPTO2. OPTO2 converts the loop current into an output voltage developed across its emitter resistor R3. The output voltage is applied across an arrangement comprising resistor R4 and diode D4, and is also applied to the input of an A/D converter 118 included within microcomputer 110. One skilled in the art will noted that A/D converter 118 may also be located outside of microcomputer 110, and coupled thereto. The arrangement of resistor R4 and diode D4 is interesting in that resistor R4 is decoupled from the circuit until the forward voltage of diode D4 is met. At that point resistors R3 and R4 are essentially in parallel.

As noted earlier, one cannot count on the line voltage provided by the telephone company to be any particular value. In fact, it may cover a wide range of values. In addition, the line monitoring circuitry must be designed to ensure proper operation at the central office under all conditions. One constraint applied to this design is that the circuitry must present an impedance to the telephone network of no more than 300 ohms at 20 milliamps (ma) DC. Another way to phrase this requirement is that the input impedance be such that it develops no more than 6 volts across it at a current of 20 ma. A series connection of diodes D1, D2, D3, is connected across resistor R1 and optoisolator OPTO2. Diodes D1, D2, and D3 limit the voltage across OPTO2 to a value which ensures that OPTO2 will not be destroyed under high telephone line voltage conditions. The voltage drop across diodes D1, D2, and D3 changes in accordance with the current through them. Resistor R2 serves to lower the voltage across the series connection of diodes D1, D2, and D3 during low current (i.e., 20 ma) operation. This ensures proper operation of central office pulse dialing under low current conditions.

In operation, the telephone line loop current is continually monitored at regular intervals. The current detector (optoisolator OPTO2) supplies a signal to A/D converter 118 which represents the level of current passing through the loop. If the current drops in a significant manner, controller 110 determines that the subscriber's extension telephone was picked up, and the controller hangs up so as not to interfere with the user's phone call.

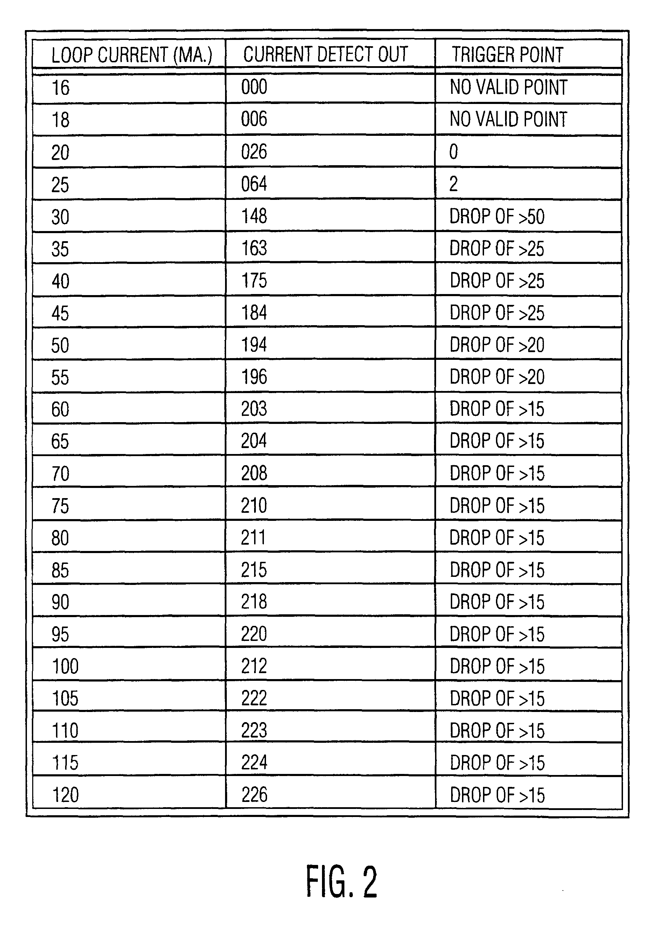

FIGURE 2 shows a table of values of loop current and corresponding carrier detector output voltages, and the recommended trigger point for making the decision as to whether or not an extension phone was picked up. It should be noted that if the loop current is relatively low (18 ma or less) then detection of extension pickup by monitoring the voltage becomes unreliable. However, the Federal Communications Commission (FCC) has specified the minimum long loop current to be provided by the telephone service provider to be 23 ma. As one can readily see from the table of FIGURE 1, the circuit of FIGURE 1 still provides a reliable trigger point with a loop current of as little as 20 ma (3 ma below the minimum allowable current). It is also noted that the current provided by the telephone company can be as high as 120 ma. The subject invention uses this recognition to provide a plurality of "trigger points" (specific voltage levels) which accommodate this wide range in order to reliably indicate that an extension phone has been picked up.

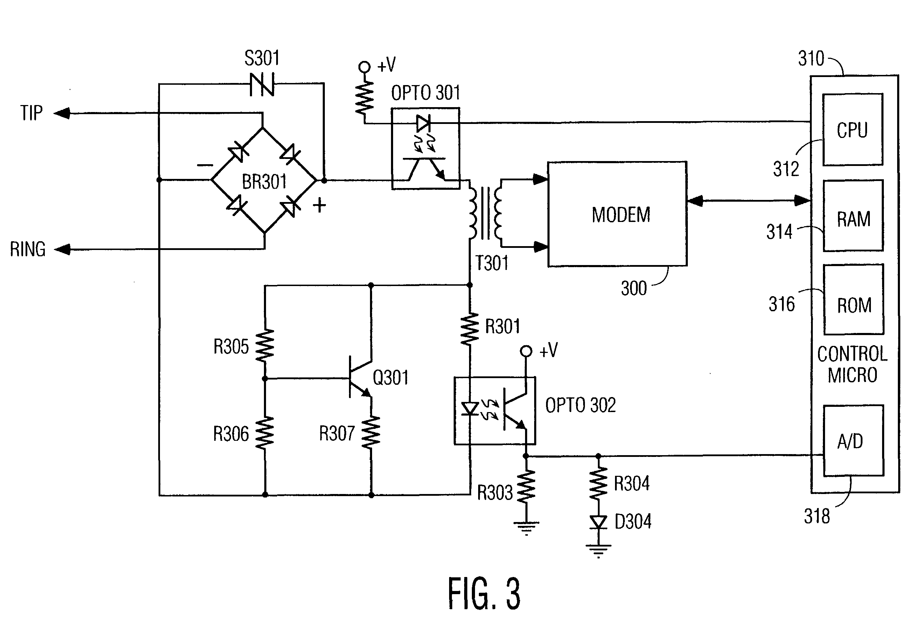

FIGURE 3 shows an alternate embodiment of the invention in which diodes D1, D2, and D3, and resistor R2, have been replaced by a transistor arrangement comprising transistor Q301, and resistors R305, R306, and R307. It is felt that the transistor arrangement may provide a more linear conversion of telephone line current to output voltage, but perhaps at the expense of slightly higher cost.

R301 (and R1 of FIGURE 1) is preferably 560 ohms. R303 (and R3) is preferably 15 kilohms. R304 (and R4) is preferably 1.5 kilohms. A typical value for resistor R305 and resistor R306 (and for R2 of FIGURE 1) is 68 ohms. This value is important in that if a relatively higher resistance value is chosen, then a voltage will be developed which is greater than the previously mentioned 6 volts at 20 ma input current. Emitter resistor R307 is preferably 7.5 ohms. Q301 may be a commonly-available 2N3904 transistor.

## Claims

1. A telephone line monitoring circuit, comprising:
telephone line connection means (OPTO1) for coupling signals to and from a telephone network;
modem means (100) for communicating with said telephone network via said connection means;
a control means (110) for providing control signals;
**characterized by**:
converting means (OPTO2) for converting telephone line current to a voltage proportional to said current;
A/D converter means (118) for sampling said voltage and providing digital samples to said control means;
said control means (110) being arranged for monitoring said samples from said A/D converter means and determining from a deviation between consecutive readings if an extension telephone coupled to said telephone line is off-hook.

2. The circuit of claim 1, wherein said converter means (OPTO2) is an optoisolator means.

3. The circuit of claim 2, further including voltage limiting means (D1, D2, D3) connected across said optoisolator means for limiting voltage developed across said optoisolator means.

4. The circuit of claim 3, wherein said voltage limiting means (D1, D2, D3) comprises a plurality of series-connected diodes.

5. The circuit of claim 4, further including resistor means (R1) connected across said voltage limiting means (D1, D2, D3) and said optoisolator means (OPTO2) for limiting voltage developed across said diode means (D1, D2, D3) during low current operation.

6. The circuit of claim 5, further including switch hook (OPTO 1) means under control of said control means (110) for establishing a connection to said telephone network.

7. The circuit of claim 3, wherein said voltage limiting means comprises an arrangement comprising a transistor means (Q301) and a resistor means (R305, R306, R307) wherein said resistor means (R305, R306, R307) and a main conduction path of said transistor means (Q301) are coupled in series, and are connected in parallel with said optoisolator means (OPTO2).

8. The circuit of claim 7, further including switch hook means (OPTO1) under control of said control means (110) for establishing a connection to said telephone network.

## Patentansprüche

1. Überwachungsschaltung für eine Telefonleitung mit:
Anschlußmitteln (OPTO1) für eine Telefonleitung zum Übertragen von Signalen zu und von einem Telefonnetz,
Modem-Mitteln (100) zur Kommunikation mit dem Telefonnetz über die Anschlußmittel,
Steuermitteln (110) zum Liefern von Steuersignalen,
**gekennzeichnet durch**
Umsetzmittel (OPTO2) zum Umsetzen des Telefonleitungsstroms in eine zu dem Strom proportionale Spannung,
A/D-Konverter-Mittel (118) zum Abtasten der Spannung und zum Liefern von digitalen Abtastwerten zu den Steuermitteln,
wobei die Steuermittel (110) die Abtastwerte von den A/D-Konvertermitteln überwachen und aus einer Abweichung zwischen aufeinanderfolgenden Ablesewerten ermitteln, ob eine mit der Telefonleitung verbundene Nebensprechstelle abgehoben ist.

2. Schaltung nach Anspruch 1, wobei die Konverter-Mittel (OPTO2) Optoisolator-Mittel sind.

3. Schaltung nach Anspruch 2, mit Spannungsbegrenzungs-Mitteln (D1, D2, D3) über den Optoisolator-Mitteln zum Begrenzen der über den Optoisolator-Mitteln gebildeten Spannung.

4. Schaltung nach Anspruch 3, wobei die Spannungsbegrenzungs-Mittel (D1, D2, D3) mehrere in Reihe geschaltete Dioden enthalten.

5. Schaltung nach Anspruch 4 mit über den Spannungsbegrenzungs-Mitteln (D1, D2, D3) und den Optoisolator-Mitteln (OPTO2) liegenden Widerstandsmitteln (R1) zum Begrenzen der Spannung über den Dioden-Mitteln (D1, D2, D3) während des laufenden Betriebs.

6. Schaltung nach Anspruch 5 mit Gabelschalter (OPTO1)-Mitteln unter Steuerung durch die Steuermittel (110) zum Herstellen einer Verbindung zu dem Telefonnetz.

7. Schaltung nach Anspruch 3, wobei die Spannungsbegrenzungs-Mittel eine Anordnung mit Transistormitteln (Q301) und Widerstandsmitteln (R305, R306, R307) enthalten und die Widerstandsmittel (R305, R306, R307) und ein Hauptleitweg der Transistormittel (Q301) in Reihe und parallel zu den Optoisofator-Mitteln (OPTO2) liegen.

8. Schaltung nach Anspruch 7 mit Gabelschalter-Mitteln (OPTO1) unter Steuerung durch die Steuermittel (110) zum Herstellen einer Verbindung zu dem Telefonnetz.

## Revendications

1. Circuit de surveillance de ligne téléphonique, comprenant :
un moyen de connexion de ligne téléphonique (OPTO1) pour coupler des signaux vers et depuis un réseau téléphonique ;
un moyen de modem (100) pour communiquer avec ledit réseau téléphonique par l'intermédiaire dudit moyen de connexion ;
un moyen de commande (110) pour fournir des signaux de commande ;
**caractérisé par** :
un moyen de conversion (OPTO2) pour convertir un courant de ligne téléphonique en une tension proportionnelle audit courant ;
un moyen de convertisseur A/N (118) pour échantillonner ladite tension et fournir des échantillons numériques audit moyen de commande ;
ledit moyen de commande (110) étant disposé pour surveiller lesdits échantillons provenant dudit moyen de convertisseur A/N et déterminer à partir d'une déviation entre des lectures consécutives si un téléphone supplémentaire couplé à ladite ligne téléphonique est décroché.

2. Circuit selon la revendication 1, dans lequel ledit moyen de convertisseur (OPTO2) est un moyen de coupleur optique.

3. Circuit selon la revendication 2, comportant en outre un moyen de limitation de tension (D1, D2, D3) connecté aux bornes dudit moyen de coupleur optique pour limiter la tension développée aux bornes dudit moyen de coupleur optique.

4. Circuit selon la revendication 3, dans lequel ledit moyen de limitation de tension (D1, D2, D3) comprend une pluralité de diodes connectées en série.

5. Circuit selon la revendication 4, comportant en outre un moyen de résistance (R1) connecté aux bornes dudit moyen de limitation de tension (D1, D2, D3) et dudit moyen de coupleur optique (OPTO2) pour limiter la tension développée aux bornes dudit moyen de diode (D1, D2, D3) durant un fonctionnement à faible courant.

6. Circuit selon la revendication 5, comportant en outre un moyen de support commutateur (OPTO 1) sous la commande dudit moyen de commande (110) pour établir une connexion avec ledit réseau téléphonique.

7. Circuit selon la revendication 3, dans lequel ledit moyen de limitation de tension comprend un agencement comprenant un moyen de transistor (Q301) et un moyen de résistance (R305, R306, R307) dans lequel ledit moyen de résistance (R305, R306, R307) et un trajet de conduction principal dudit moyen de transistor (Q301) sont couplés en série, et sont connectés en parallèle audit moyen de coupleur optique (OPTO2).

8. Circuit selon la revendication 7, comportant en outre un moyen de support commutateur (OPTO1) sous la commande dudit moyen de commande (110) pour établir une connexion avec ledit réseau téléphonique.
